# EUROPEAN PATENT APPLICATION

(11) **EP 3 422 564 A1**
(43) Date of publication of application: **02.01.2019**
(21) Application number: 18180119.2
(22) Date of filing: 27.06.2018
(51) Int. Cl.: H02S 10/40, H02S 20/20

(54) **PHOTOVOLTAIC VEHICLE ROOF**

(30) Priority: 30.06.2017 CN 201720783912 U; 30.06.2017 CN 201720782850 U
(71) Applicant: Beijing Hanergy Solar Power Investment Co., Ltd., 101499 Beijing (CN)
(72) Inventor: Lu, Penghui, Beijing, Beijing 101499 (CN); Zhang, Dapeng, Beijing, Beijing 101499 (CN); Hu, Baoyi, Beijing, Beijing 101499 (CN)
(74) Representative: Cohausz & Florack

(57) **Abstract**

The disclosure provides a photovoltaic vehicle roof. The photovoltaic vehicle roof comprises a structural layer including a flat-plate or single-curve surface shaped power generation zone (4) and a transition zone disposed around the power generation zone (4), and a photovoltaic module layer including a flexible photovoltaic thin-film module (1) secured to an upper surface of the power generation zone (4). The present disclosure adopts a single-curve surface or flat-plate shaped power generation zone (4), and only needs to lay the flexible photovoltaic thin-film module (1) on the power generation zone (4). The process is simple and convenient, and can effectively prolong the service life of the photovoltaic vehicle roof since no complex stress will be generated.

## Description

### CROSS-REFERENCE TO RELATED APPLICATION

This application claims the priority of Chinese Patent Applications No. 201720783912.X and No. 201720782850.0 submitted to the Chinese Intellectual Property Office on June 30, 2017, the disclosures of both are incorporated herein in its entirety by reference.

### TECHNICAL FIELD

The present disclosure relates to the technical field of solar power generation, and particularly relates to a photovoltaic vehicle roof that can generate electricity under light.

### BACKGROUND OF THE INVENTION

Solar cars are formed by placing a solar module on a vehicle roof thereof so that the solar module can supplement power for the car's energy storage system under light. Currently, solar modules are usually installed on the vehicle roof by firstly installing a fixing frame on the vehicle roof, and then installing the solar module onto the fixed frame; or by providing an integral vehicle roof formed by laminating the solar module and the vehicle roof; both of the two can install the solar module on the vehicle roof successfully.

However, the former requires manufacturing a corresponding fixing frame first, and then assembling the fixing frame with the vehicle roof and the module, which involves numerous parts and tedious procedures; while the latter requires laminating the vehicle roof and the solar module after the vehicle roof has been punched, which lamination process takes a long time.

### SUMMARY

The present disclosure has been accomplished in order to at least partially solve the problems in the prior art. The present disclosure provides a photovoltaic vehicle roof that can save time and be installed easily and reliably.

According to one aspect of the disclosure, there is provided a photovoltaic vehicle roof, comprising:
a structural layer including a flat-plate or single-curve surface shaped power generation zone and a transition zone disposed around the power generation zone; and
a photovoltaic module layer including a flexible photovoltaic thin-film module secured to an upper surface of the power generation zone.

The power generation zone may have a flat-plate shape, the transition zone includes two first transition zones respectively connected to two opposite sides of the power generation zone and two second transition zones respectively connected to other two sides of the power generation zone; the first and second transition zones both have a single-curved surface shape, a generatrix parallel to a corresponding edge of the power generation zone, and a lower surface fitted to an upper surface of the vehicle roof.

The power generation zone may have a single-curved surface shape, the transition zone includes two first transition zones respectively connected to two arc edges of the power generation zone and two second transition zones respectively connected to two linear edges of the power generation zone;
the first transition zone has a hyperboloid shape, an upper edge at a side thereof tangent to and connected to the power generation zone, and a lower surface fitted to an upper surface of the vehicle roof; and
the second transition zone has a single-curved surface shape, an upper edge at a side thereof tangent to and connected to the power generation zone, and a lower surface fitted to the upper surface of the vehicle roof.

A generatrix of the power generation zone may be perpendicular to a front-rear direction of the vehicle roof.

The generatrix of the power generation zone may be parallel to a front-rear direction of the vehicle roof.

The power generation zone may be provided with a though hole or recess into which a junction box of the flexible photovoltaic thin-film module is disposed with a sealed connection between an edge of the junction box and the through hole or recess.

The recess may have a depth the same as a thickness of the junction box.

The flexible photovoltaic thin-film module may be in a sealed connection with the power generation zone.

The power generation zone may have a single-curved surface shape, the transition zone includes two first transition zones respectively connected to two arc edges of the power generation zone and two second transition zones respectively connected to two linear edges of the power generation zone;
the first transition zone has a single-curved surface shape, an upper edge at a side thereof tangent to and connected to the power generation zone, and a lower surface fitted to an upper surface of the vehicle roof; and
the second transition zone has a single-curved surface shape, an upper edge at a side thereof tangent to and connected to the power generation zone, and a lower surface fitted to the upper surface of the vehicle roof.

The power generation zone may be a recess bottom surface of a recess disposed in the middle of the structural layer.

An upper surface of the flexible photovoltaic thin-film module may be in a smooth transition with an upper surface of the transition zone.

The recess bottom surface may have a flat-plate shape, the transition zone includes two first transition zones respectively corresponding to two opposite sides of the recess bottom surface and two second transition zones respectively corresponding to other two sides of the recess bottom surface, and the first and second transition zones both have a single-curved surface shape and a generatrix parallel to a corresponding edge of the recess bottom surface.

The recess bottom surface may have a single-curved surface shape, the transition zone includes two first transition zones respectively corresponding to two arc edges of the recess bottom surface and two second transition zones respectively corresponding to two linear edges of the recess bottom surface;
the first transition zone has a hyperboloid shape, and an upper edge at a side thereof parallel to an arc edge of the recess bottom surface; and
the second transition zone has a single-curved surface shape, and a generatrix parallel to a generatrix of the recess bottom surface.

The generatrix of the recess bottom surface may be parallel to a front-rear direction of the vehicle roof.

The generatrix of the recess bottom surface may be perpendicular to a front-rear direction of the vehicle roof.

The recess bottom surface may be provided with a though hole or sink into which a junction box of the flexible photovoltaic thin-film module is disposed.

A distance from the flexible photovoltaic thin-film module to a side of the recess may be no greater than 10mm.

The flexible photovoltaic thin-film module is in a sealed connection with the recess bottom surface or side at least at an edge, and a sealing material is filled between the flexible photovoltaic thin-film module and the recess side.

The recess may be a channel with an opening connected to a vehicle body at both ends and two closed sides connected to the transition zone;
a bottom surface of the channel has a flat-plate or sing-curved surface shape.

### BRIEF DESCRIPTION OF THE FIGURES

Fig. 1 is a structural schematic view showing a photovoltaic vehicle roof according to the first exemplary embodiment of the disclosure;
Fig. 2 is a cross-sectional view taken along line A-A of Fig. 1;
Fig. 3 is a cross-sectional view taken along line B-B of Fig. 1;
Fig. 4 is a structural schematic view showing a photovoltaic vehicle roof according to the second exemplary embodiment of the disclosure;
Fig. 5 is a cross-sectional view taken along line C-C of Fig. 4;
Fig. 6 is a cross-sectional view taken along line D-D of Fig. 4;
Fig. 7 is a structural schematic view showing a photovoltaic vehicle roof according to the sixth exemplary embodiment of the disclosure;
Fig. 8 is a cross-sectional view taken along line E-E of Fig. 7;
Fig. 9 is a cross-sectional view taken along line F-F of Fig. 7;
Fig. 10 is a structural schematic view showing a photovoltaic vehicle roof according to the seventh exemplary embodiment of the disclosure;
Fig. 11 is a cross-sectional view taken along line G-G of Fig. 10; and
Fig. 12 is a cross-sectional view taken along line H-H of Fig. 10.

### DETAILED DESCRIPTION

The disclosure will now be further explained in detail in conjunction with the accompanying drawings. It should be appreciated that the embodiments described below with reference to the drawings are merely illustrative, and are used only for the purpose of explaining the disclosure and should not be interpreted as limitations to the disclosure.

As used in the disclosure, "front" refers to a vehicle head direction, "rear" refers to a vehicle tail direction, "left" and "right" refer to left and right sides when facing the vehicle head and backing to the vehicle tail.

As used in the disclosure, "single-curved surface" means a curved surface formed by a trajectory along which a straight line as a generatrix slides along a curved line, while "hyperboloid" means a curved surface formed by a trajectory along which a curved line as a generatrix slides along another curved line. For a single-curved surface, the generatrix shall be perpendicular to a plane where the curved line is located; for a hyperboloid, the generatrix shall be perpendicular to a plane where the another curved line is located.

As used in the disclosure, the term "recess" means the material surface in one area is lower than in other areas, and the material of this area is connected to the material of the other areas, for instance, a recess formed by punching a plate-shaped part. The term "sink" means the material surface in one area is lower than in other areas, and the material in the other areas forms an enclosure structure. The term "channel" means the material surface in one area is lower than in other areas, and the material in the other areas is distributed at opposite sides of the area, for instance, a channel with a U-shaped cross section.

### First Exemplary Embodiment

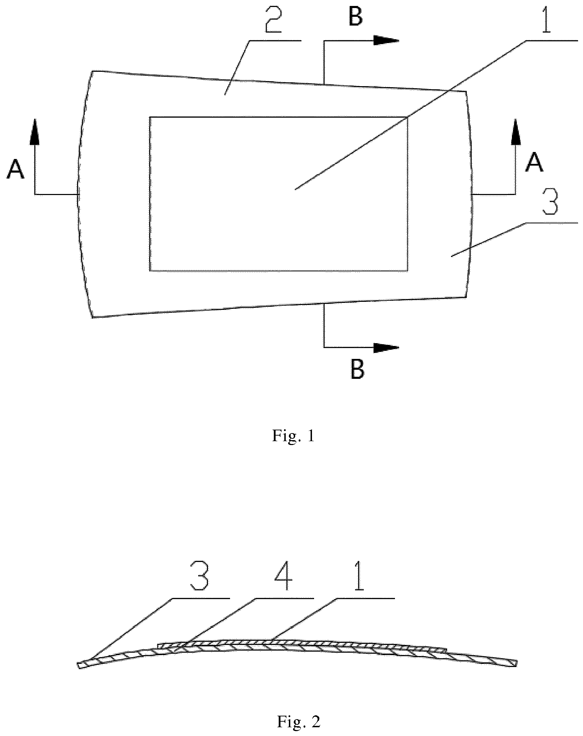

As shown in Figs. 1-3, the exemplary embodiment provides a photovoltaic vehicle roof including a structural layer with a single-curved surface shaped power generation zone 4 disposed in the middle thereof. The power generation zone 4 has a generatrix extending in a left-right direction and forming the single-curved surface of the power generation zone 4 by moving along a trajectory curve extending in a front-rear direction. A transition zone, as an enclosure structure, is provided around the power generation zone 4. The transition zone includes two second transition zones (or transition bars) 3 respectively disposed at front and back sides of the power generation zone 4. The second transition zone 3 has a trajectory curve segment extending in the front-rear direction, and a generatrix parallel to the generatrix of the power generation zone 4. The transition zone also includes two first transition zones 2 at left and right sides of the power generation zone 4. The first transition zone 2 has a generatrix parallel to the generatrix of the power generation zone 4, and a trajectory curve segment parallel to that of the power generation zone 4.

Specifically, in the exemplary embodiment, the power generation zone 4 has a single-curve surface shape, the two first transition zones 2 are respectively connected to two arc edges of the power generation zone 4, and the two second transition zones 3 are respectively connected to two linear edges of the power generation zone 4. The first transition zone 2 has a single-curved surface shape, an upper edge at a side thereof tangent to and connected to the power generation zone 4, and a lower surface fitted to an upper surface of the vehicle roof. The second transition zone 3 has a single-curved surface shape, an upper edge at a side thereof tangent to and connected to the power generation zone 4, and a lower surface fitted to the upper surface of the vehicle roof.

In the exemplary embodiment, the first transition zone 2 and the second transition zone 3 are connected with each other with a smooth transition. The connection between the first transition zone 2 and the second transition zone 3, as well as between the first and second transition zones 2, 3 and the power generation zone 4, may be realized by welding, bonding, riveting, bolting, or the like, or these parts may be shaped by punching, casting, or any other one-piece molding method.

A flexible photovoltaic thin-film module 1 is directly laid on the power generation zone 4. The flexible photovoltaic thin-film module 1 may be connected to the power generation zone 4 by welding, bonding, riveting, or the like, or may be fixed by being pressed with a pressing strip (for example, glazing bead).

Since the power generation zone 4 in the embodiment has a single-curved surface shape, the flexible photovoltaic thin-film module 1 can be directly laid on the power generation zone 4 so that after the laying is completed, the flexible photovoltaic thin-film module 1 is only bent in a single direction, and a three-dimensional stress will not occur, thus reducing the installation difficulty to some extent, significantly improving the installation effect and prolonging the service life.

In order to maintain a smooth shape of the vehicle roof after installation of the solar module, a sink is machined in the power generation zone 4, into which a junction box of the flexible photovoltaic thin-film module 1 is installed. In order to ensure flatness of the flexible photovoltaic thin-film module 1, it is preferable to machine a depth of the sink to be the same as a thickness of the junction box. Obviously, the installation method of the junction box in the exemplary embodiment may also be applied to the following second to fifth exemplary embodiments.

### Second Exemplary Embodiment

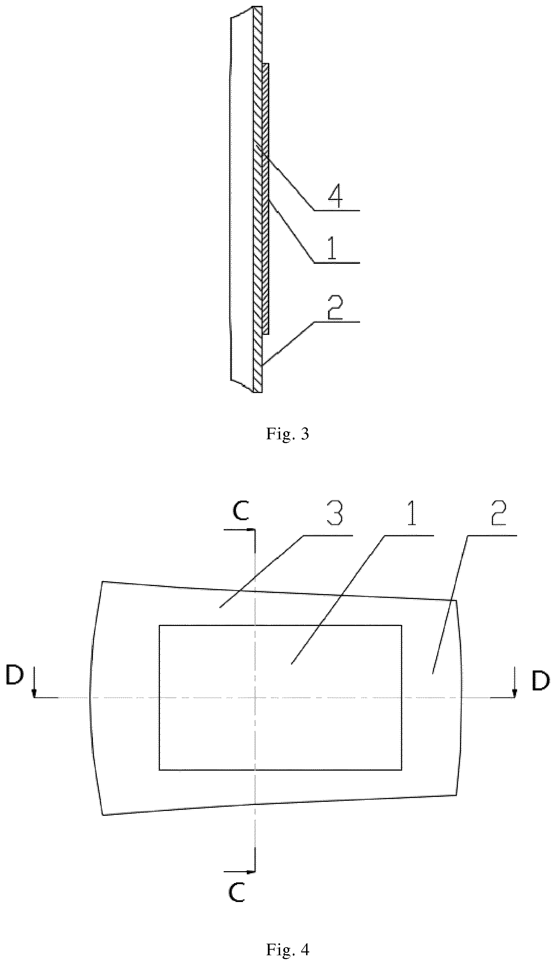

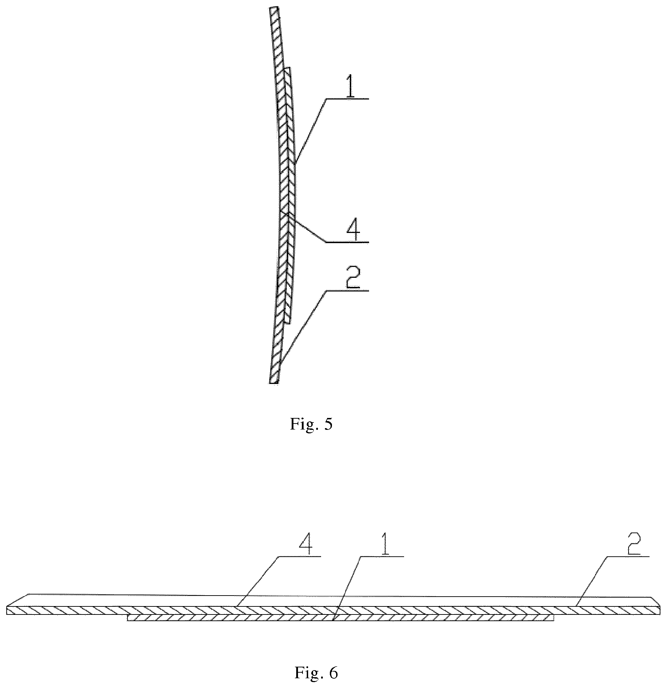

As shown in Figs. 4-6, the exemplary embodiment provides a photovoltaic vehicle roof including a structural layer with a power generation zone 4 disposed in the middle thereof, and a transition zone as an enclosure structure around the power generation zone 4. The power generation zone 4 has a single-curve surface shape, and a generatrix extending in a front-rear direction with a trajectory curve extending in a left-right direction. The transition zone includes two first transition zones 2 respectively disposed at front and rear sides of the power generation zone 4. The first transition zone 2 has a single-curved surface shape, and a generatrix parallel to the generatrix of the power generation zone 4 with a trajectory curve located in a plane parallel to a plane where the trajectory curve of the generatrix of the power generation zone 4 is located. The transition zone also includes two second transition zones 3 at left and right sides of the power generation zone 4. The second transition zone 3 has a single-curved surface shape, and a generatrix parallel to the generatrix of the power generation zone 4 with a trajectory curve tangent to that of the power generation zone 4.

Specifically, in the exemplary embodiment, the power generation zone 4 has a single-curve surface shape, the two first transition zones 2 are respectively connected to two arc edges of the power generation zone 4, and the two second transition zones 3 are respectively connected to two linear edges of the power generation zone 4. An upper edge at a side of the first transition zone 2 is tangent to and connected to the power generation zone 4, and a lower surface of the first transition zone 2 is fitted to an upper surface of the vehicle roof. An upper edge at a side of the second transition zone 3 is tangent to and connected to the power generation zone 4, and a lower surface of the second transition zone 3 is fitted to the upper surface of the vehicle roof.

In the exemplary embodiment, the first transition zone 2 and the second transition zone 3 are connected with each other with a smooth transition. The connection between the first transition zone 2 and the second transition zone 3, as well as between the first and second transition zones 2, 3 and the power generation zone 4, may be realized by welding, bonding, riveting, bolting, or the like, or these parts may be shaped by punching, casting, or any other one-piece molding method.

A flexible photovoltaic thin-film module 1 is directly laid on the power generation zone 4. The flexible photovoltaic thin-film module 1 may be connected to the power generation zone 4 by welding, bonding, riveting, or the like, or may be fixed by being pressed with a pressing strip.

Since the power generation zone 4 in the present embodiment has a single-curved surface shape, the flexible photovoltaic thin-film module 1 can be directly laid on the power generation zone 4 so that after the laying is completed, the flexible photovoltaic thin-film module 1 is only bent in a single direction, and a three-dimensional stress will not occur, thus reducing the installation difficulty to some extent, significantly improving the installation effect and prolonging the service life.

### Third Exemplary Embodiment

The exemplary embodiment provides a photovoltaic vehicle roof including a structural layer with a single-curved surface shaped power generation zone disposed in the middle thereof. The power generation zone has a generatrix extending in a left-right direction and forming the single-curved surface of the power generation zone by moving along a trajectory curve extending in a front-rear direction. A transition zone, as an enclosure structure, is provided around the power generation zone. The transition zone includes two second transition zones respectively disposed at front and back sides of the power generation zone. The second transition zone has a trajectory curve segment extending in the front-rear direction, and a generatrix parallel to the generatrix of the power generation zone. The transition zone also includes two hyperboloid shaped first transition zones at left and right sides of the power generation zone. The first transition zone has a generatrix tangent to the generatrix of the power generation zone at an end (or a top end), and a trajectory curve segment parallel to that of the power generation zone.

Specifically, in the exemplary embodiment, the power generation zone has a single-curve surface shape, the two first transition zones are respectively connected to two arc edges of the power generation zone, and the two second transition zones are respectively connected to two linear edges of the power generation zone. The first transition zone has a hyperboloid shape, an upper edge at a side thereof tangent to and connected to the power generation zone, and a lower surface fitted to an upper surface of the vehicle roof. The second transition zone has a single-curved surface shape, an upper edge at a side thereof tangent to and connected to the power generation zone, and a lower surface fitted to the upper surface of the vehicle roof.

In the exemplary embodiment, the first transition zone and the second transition zone are connected with each other with a smooth transition. The connection between the first transition zone and the second transition zone, as well as between the first and second transition zones and the power generation zone, may be realized by welding, bonding, riveting, bolting, or the like, or these parts may be shaped by punching, casting, or any other one-piece molding method.

A flexible photovoltaic thin-film module is directly laid on the power generation zone. The flexible photovoltaic thin-film module may be connected to the power generation zone by welding, bonding, riveting, or the like, or may be fixed by being pressed with a pressing strip.

Since the power generation zone in the present embodiment has a single-curved surface shape, the flexible photovoltaic thin-film module can be directly laid on the power generation zone so that after the laying is completed, the flexible photovoltaic thin-film module is only bent in a single direction, and a three-dimensional stress will not occur, thus reducing the installation difficulty to some extent, significantly improving the installation effect and prolonging the service life.

### Fourth Exemplary Embodiment

The exemplary embodiment provides a photovoltaic vehicle roof including a structural layer with a power generation zone disposed in the middle thereof, and a transition zone as an enclosure structure around the power generation zone. The power generation zone has a single-curve surface shape, and a generatrix extending in a front-rear direction with a trajectory curve extending in a left-right direction. The transition zone includes two first transition zones respectively disposed at front and rear sides of the power generation zone. The first transition zone has a hyperboloid shape, and a generatrix parallel to a trajectory curve of the power generation zone, and a trajectory curve of the generatrix of the first transition zone is located in a plane parallel to the generatrix of the power generation zone. The transition zone also includes two second transition zones at left and right sides of the power generation zone. The second transition zone has a single-curved surface shape, and a generatrix parallel to the generatrix of the power generation zone with a trajectory curve tangent to that of the power generation zone.

Specifically, in the exemplary embodiment, the power generation zone has a single-curve surface shape, the two first transition zones are respectively connected to two arc edges of the power generation zone, and the two second transition zones are respectively connected to two linear edges of the power generation zone. The first transition zone has a hyperboloid shape, an upper edge at a side thereof tangent to and connected to the power generation zone, and a lower surface fitted to an upper surface of the vehicle roof. The second transition zone has a single-curved surface shape, an upper edge at a side thereof tangent to and connected to the power generation zone, and a lower surface fitted to the upper surface of the vehicle roof.

In the exemplary embodiment, the first transition zone and the second transition zone are connected with each other with a smooth transition. The connection between the first transition zone and the second transition zone, as well as between the first and second transition zones and the power generation zone, may be realized by welding, bonding, riveting, bolting, or the like, or these parts may be shaped by punching, casting, or any other one-piece molding method.

A flexible photovoltaic thin-film module is directly laid on the power generation zone. The flexible photovoltaic thin-film module may be connected to the power generation zone by welding, bonding, riveting, or the like, or may be fixed by being pressed with a pressing strip.

Since the power generation zone in the present embodiment has a single-curved surface shape, the flexible photovoltaic thin-film module can be directly laid on the power generation zone so that after the laying is completed, the flexible photovoltaic thin-film module is only bent in a single direction, and a three-dimensional stress will not occur, thus reducing the installation difficulty to some extent, significantly improving the installation effect and prolonging the service life.

### Fifth Exemplary Embodiment

The exemplary embodiment provides a photovoltaic vehicle roof including a structural layer (or support layer) with a flat-plate shaped power generation zone disposed in the middle thereof, and a transition zone around the power generation zone. The transition zone includes second transition zones (or side transition bars) at front and rear sides of the power generation zone and first transition zones (or edge transition bars) at left and right sides of the power generation zone, the first transition zone and the second transition zone both have a single-curved surface shape, and a generatrix of the second transition zone at the front side is parallel to a front edge of the power generation zone, and similarly, a generatrix of the second transitional zone at the rear side is parallel to a back edge of the power generation zone, a generatrix of the first transition zone at the left side is parallel to a left edge of the power generation zone, and a generatrix of the first transition zone at the right side is parallel to a right edge of the power generation zone.

Specifically, in the exemplary embodiment, the power generation zone has a flat-plate shape, the two first transition zones are respectively connected to opposite sides of the power generation zone, and the two second transition zones are respectively connected to other two sides of the power generation zone. The first and second transition zones both have a single-curved surface shape, a generatrix parallel to corresponding edges of the power generation zone, and a lower surface fitted to an upper surface of the vehicle roof.

In the exemplary embodiment, the first transition zone and the second transition zone are connected with each other with a smooth transition. The connection between the first transition zone and the second transition zone, as well as between the first and second transition zones and the power generation zone, may be realized by welding, bonding, riveting, bolting, or the like, or these parts may be shaped by punching, casting, or any other one-piece molding method.

A flexible photovoltaic thin-film module is directly laid on the power generation zone. The flexible photovoltaic thin-film module may be connected to the power generation zone by welding, bonding, riveting, or the like, or may be fixed by being pressed with a pressing strip.

Since the power generation zone in the exemplary embodiment has a flat-plate shape, the flexible photovoltaic thin-film module can be directly laid on the power generation zone so that after the laying is completed, no strain occurs on the flexible photovoltaic thin-film module and substantially no stress will be generated, thus reducing the installation difficulty to some extent, significantly improving the installation security and prolonging the service life.

### Sixth Exemplary Embodiment

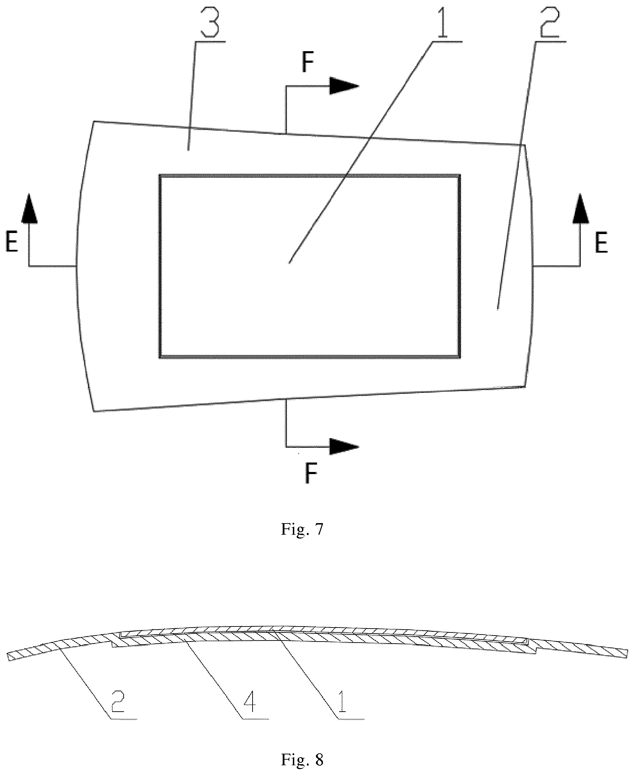

As shown in Figs. 7-9, the exemplary embodiment provides a photovoltaic vehicle roof including a structural layer and a flexible photovoltaic thin-film module 1 installed on the structural layer. A sink (or recess) is provided in the middle of the structural layer, which has a bottom surface 4 with a single-curved surface shape. A generatrix of the single-curved surface is a straight line segment extending in a let-right direction. The generatrix moves along a trajectory curve segment of the bottom surface 4 extending in a front-rear direction to form the single-curved surface. A transition zone is provided around the sink, which includes second transition zones 2 at front and rear ends of the sink and first transition zones 3 at left and right sides of the sink. The second transition zone 2 has a single-curved surface shape, and a generatrix being a straight line segment parallel to a generatrix of the power generation zone 4. The straight line segment moves along a trajectory curve segment of the second transition zone 2 extending in the front-rear direction to form the single-curved surface. The first transition zone 3 is a single-curved surface plate with a generatrix being a straight line segment. The straight line segment moves along a trajectory curve segment of the first transition zone 3 extending in the front-rear direction to form the single-curved surface plate. A portion of the trajectory curve segment of the first transition zone 3 corresponding to the sink is parallel to the trajectory curve segment of the bottom surface 4, and a portion of the trajectory curve segment of the first transition zone 3 corresponding to the second transition zone 2 is parallel to the trajectory curve segment of the second transition zone 2.

The connection method between the transition zone and edges of the sink includes, but not limited to, welding, bonding, riveting, bolting, or the like. Obviously, the sink and the transition zone may be integrally shaped by, for example, punching.

As shown in Figs. 7-9, the flexible photovoltaic thin-film module 1 is installed in the sink and fixed by welding, bonding, riveting, or bolting, or being pressed with a pressing strip, or the like.

In order to install a junction box of the flexible photovoltaic thin-film module 1 on a lower surface thereof, a through hole into which the junction box is installed is opened in the sink bottom surface 4. Thus, flatness in the surface of the flexible photovoltaic thin-film module 1 is ensured. Obviously, a small sink into which the junction box is installed may be punched on the sink bottom surface 4, so as to ensure flatness in the surface of the flexible photovoltaic thin-film module 1.

Edges of the flexible photovoltaic thin-film module 1 are in a sealed connection with the sink bottom surface 4. In this way, contaminants such as rainwater can be prevented from entering between the sink bottom surface 4 and the flexible photovoltaic thin-film module 1. In addition, in order to avoid stress changes caused by the structural layer and the flexible photovoltaic thin-film module 1 due to differences in the temperature-induced contraction rate, a space of 10 mm is left between the flexible photovoltaic thin-film module 1 and edges of the sink. In order to avoid contamination within the space, the space will be filled with a sealing material.

In the photovoltaic vehicle roof of the exemplary embodiment, a sink is formed in the middle of the structural layer, and then the flexible photovoltaic thin-film module 1 is directly installed into the sink so that it does not require a large number of parts or tedious procedures, thus realizing a very quick installation process and significantly reducing time and economic costs.

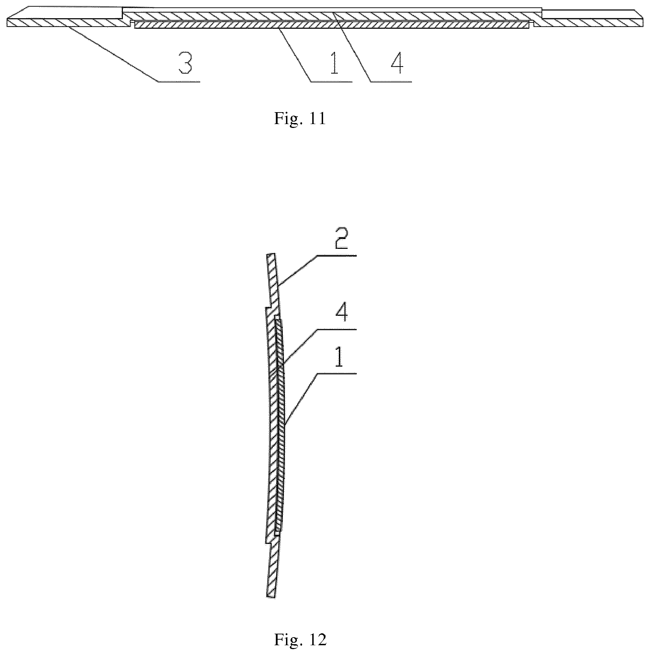

It should be noted that in the first to fifth exemplary embodiments, as shown in Figs. 1-6, the upper surface of the photovoltaic vehicle roof is higher than the upper surface of the transition zone, but in the sixth to tenth exemplary embodiments, as shown in Figs. 7 to 12, the upper surface of the photovoltaic vehicle roof is lower than the upper surface of the transition zone. In other words, in the sixth to tenth exemplary embodiments, the power generation zone in the first to fifth exemplary embodiments corresponds to the recess bottom surface of the recess disposed in the middle of the structural layer, and the upper surface of the flexible photovoltaic thin-film module has a smooth transition with the upper surface of the transition zone.

### Seventh Exemplary Embodiment

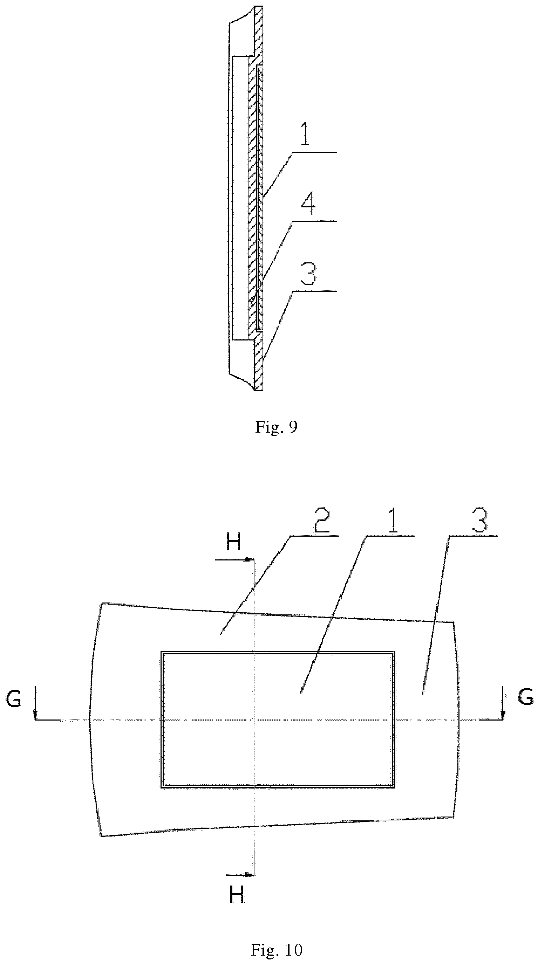

As shown in Figs. 10-12, the exemplary embodiment provides a photovoltaic vehicle roof including a structural layer with a sink provided in the middle thereof. The sink has a bottom surface 4 with a single-curved surface shape. A generatrix of the single-curved surface shape is a straight line segment extending in a let-right direction. The generatrix moves along a trajectory curve segment of the bottom surface 4 extending in a front-rear direction to form the single-curved surface. A transition zone is provided around the sink, which includes first transition zones 3 at front and rear ends of the sink and second transition zones 2 at left and right sides of the sink. The first transition zone 3 has a single-curved surface shape, and a generatrix being a straight line segment parallel to the generatrix of the sink bottom surface 4. The straight line segment moves along a trajectory curve segment of the first transition zone 3 extending in the front-rear direction to form the single-curved surface. The second transition zone 2 has a hyperboloid shape, and a generatrix being a curve segment extending in the left-right direction. The curve segment moves along a trajectory curve segment of the second transition zone 2 extending in the front-rear direction to form the hyperboloid. A portion of the trajectory curve segment of the second transition zone 2 corresponding to the sink is parallel to the trajectory curve segment of the bottom surface 4, and a portion of the trajectory curve segment of the second transition zone 2 corresponding to the first transition zone 3 is parallel to the trajectory curve segment of the first transition zone 3.

Specifically, in the exemplary embodiment, the sink bottom surface has a single-curve surface shape, the two first transition zones are respectively disposed corresponding to two linear edges of the sink bottom surface, and the two second transition zones are respectively disposed corresponding to two arc edges of the sink bottom surface. The first transition zone has a single-curved surface shape, and a generatrix parallel to the generatrix of the sink bottom surface. The second transition zone has a hyperboloid shape, and an upper edge at a side thereof parallel to an arc edge of the recess bottom surface.

The connection method between the transition zone and edges of the sink includes, but not limited to, welding, bonding, riveting, bolting, or the like. Obviously, the sink and the transition zone may be integrally shaped by, for example, punching.

As shown in Figs. 10-12, the flexible photovoltaic thin-film module 1 is installed in the sink and fixed by welding, bonding, riveting, or bolting, or being pressed with a pressing strip, or the like.

In order to install a junction box of the flexible photovoltaic thin-film module 1 on a lower surface thereof, a through hole into which the junction box is installed is opened in the sink bottom surface 4. Thus, flatness in the surface of the flexible photovoltaic thin-film module 1 is ensured. Obviously, a small sink into which the junction box is installed may be punched on the sink bottom surface 4, so as to ensure flatness in the surface of the flexible photovoltaic thin-film module 1.

Edges of the flexible photovoltaic thin-film module 1 are in a sealed connection with the sink bottom surface 4. In this way, contaminants such as rainwater can be prevented from entering between the sink bottom surface 4 and the flexible photovoltaic thin-film module 1. In addition, in order to avoid stress changes caused by the structural layer and the flexible photovoltaic thin-film module 1 due to differences in the temperature-induced contraction rate, a space of 10 mm is left between the flexible photovoltaic thin-film module 1 and edges of the sink. In order to avoid contamination within the space, the space will be filled with a sealing material.

In the photovoltaic vehicle roof of the exemplary embodiment, a sink is formed in the middle of the structural layer, and then the flexible photovoltaic thin-film module 1 is directly installed into the sink so that it does not require a large number of parts or tedious procedures, thus realizing a very quick installation process and significantly reducing time and economic costs.

### Eighth Exemplary Embodiment

The exemplary embodiment provides a photovoltaic vehicle roof, which differs from the sixth exemplary embodiment in that: the sink bottom surface in this exemplary embodiment has a single-curved surface shape, but the generatrix thereof extends in a front-rear direction while the trajectory curve of the bottom surface extends in a left-right direction. In the exemplary embodiment, the second transition zone at the front and rear ends of the sink has a single-curved surface shape, and a generatrix parallel to the generatrix of the bottom surface; the first transition zone at the left and right sides of the sink has a single-curved surface shape, and a generatrix parallel to the generatrix of the bottom surface. A connecting portion between the first and second transition zones has a smooth transition. Obviously, the second transition zone may also be machined into a hyperboloid shape with a tangent line at a top thereof parallel to the generatrix of the sink bottom surface.

### Ninth Exemplary Embodiment

The embodiment provides a photovoltaic vehicle roof including a structural layer with sink having a flat-plate shaped bottom surface disposed in the middle thereof, and a transition zone around the sink which includes second transition zones at front and rear ends of the sink and first transition zones at left and right sides of the sink, the first and second transition zones both have a single-curved surface shape, a generatrix of the second transition zone at the front end is parallel to a front edge of the sink bottom surface, and similarly, a generatrix of the second transition zone at the rear end is parallel to a rear edge of the sink bottom surface, a generatrix of the first transition zone at the left side is parallel to a left edge of the sink bottom surface, and a generatrix of the first transition zone at the right side is parallel to a right edge of the sink bottom surface.

A flexible photovoltaic thin-film module is installed in the sink and fixed by welding, bonding, riveting, or bolting, or being pressed with a pressing strip, or the like.

In order to install a junction box of the flexible photovoltaic thin-film module on a lower surface thereof, a through hole into which the junction box is installed is opened in the sink bottom surface. Thus, flatness in the surface of the flexible photovoltaic thin-film module is ensured. Obviously, a small sink into which the junction box is installed may be punched on the sink bottom, so as to ensure flatness in the surface of the flexible photovoltaic thin-film module.

Edges of the flexible photovoltaic thin-film module are in a sealed connection with the sink bottom surface. In this way, contaminants such as rainwater can be prevented from entering between the sink bottom surface and the flexible photovoltaic thin-film module. In addition, in order to avoid stress changes caused by the structural layer and the flexible photovoltaic thin-film module due to differences in the temperature-induced contraction rate, a space of 10 mm is left between the flexible photovoltaic thin-film module and edges of the sink. In order to avoid contamination within the space, the space will be filled with a sealing material.

In the photovoltaic vehicle roof of the exemplary embodiment, a sink is formed in the middle of the structural layer, and then the flexible photovoltaic thin-film module is directly installed in the sink so that it does not require a large number of parts or tedious procedures, thus realizing a very quick installation process and significantly reducing time and economic costs.

Since the sink bottom surface in the exemplary embodiment has a flat-plate shape, substantially no stress will be generated when the flexible photovoltaic thin-film module is laid thereon, which is advantageous for extending the service life of the flexible photovoltaic thin-film module.

### Tenth Exemplary Embodiment

The exemplary embodiment provides a photovoltaic vehicle roof including a structural layer with a channel provided in the middle thereof, the channel having a bottom surface with a single-curved surface shape. Left and right sides of the channel are connected with a transition zone having a single-curved surface shape with a generatrix parallel to a generatrix of the channel bottom surface. Both front and rear ends of the transition zone and the channel are connected with a vehicle body, an outer edge of the transition zone is connected with the vehicle body, and the flexible photovoltaic thin-film module is installed in the channel. A sink or a through hole is provided on the bottom surface of the channel, into which a junction box of the flexible photovoltaic thin-film module is installed. Similarly, the channel and the transition zone in the embodiment may be connected by welding, bonding, riveting, bolting, or the like, or may be integrally formed by punching, casting, or the like. The flexible photovoltaic thin-film module in the embodiment may also be fixed by welding, bonding, riveting, bolting, being pressed by a pressing strip, or the like.

In the exemplary embodiment, the generatrix of the channel bottom surface may also be installed along the front-rear direction. Then, the transition zone will be located at front and rear sides of the vehicle body.

In the exemplary embodiment, the transition zone may also be machined into a hyperboloid shape, with a tangent line at a top thereof parallel to the generatrix of the channel bottom surface, and a trajectory parallel to the trajectory of the channel bottom surface.

In the embodiment, the channel bottom surface may also have a flat-plate shape. If so, the transition zone can only be a single-curved surface instead of a hyperboloid. When the transition zone is at the left side of the channel, the generatrix of the transition zone is parallel to the left side of the channel bottom surface. Similarly, when the transition zone is at the front, rear or right side, the generatrix of the transition zone is parallel to the front, rear or right side of the channel bottom surface.

The foregoing embodiments are merely preferred embodiments of the present disclosure, but the protection scope of the disclosure is not limited thereto. Any change or alternative that can be easily thought by those skilled in the art within the technical scope disclosed by the disclosure shall fall in the protection scope of the disclosure. Therefore, the protection scope of the disclosure should be based on the protection scope defined by the claims.

## Claims

1. A photovoltaic vehicle roof, comprising:
a structural layer including a flat-plate or single-curve surface shaped power generation zone (4) and a transition zone disposed around the power generation zone (4); and
a photovoltaic module layer including a flexible photovoltaic thin-film module (1) secured to an upper surface of the power generation zone (4).

2. The photovoltaic vehicle roof according to claim 1, wherein the power generation zone (4) has a flat-plate shape, the transition zone includes two first transition zones (2,3) respectively connected to two opposite sides of the power generation zone (4) and two second transition zones (3,2) respectively connected to other two sides of the power generation zone (4); the first and second transition zones both have a single-curved surface shape, a generatrix parallel to a corresponding edge of the power generation zone (4), and a lower surface fitted to an upper surface of the vehicle roof.

3. The photovoltaic vehicle roof according to claim 1,
wherein the power generation zone (4) has a single-curved surface shape, the transition zone includes two first transition zones (2,3) respectively connected to two arc edges of the power generation zone (4) and two second transition zones (3,2) respectively connected to two linear edges of the power generation zone (4);
wherein the first transition zone (2,3) has a hyperboloid shape, an upper edge at a side thereof tangent to and connected to the power generation zone (4), and a lower surface fitted to an upper surface of the vehicle roof; and
wherein the second transition zone (3,2) has a single-curved surface shape, an upper edge at a side thereof tangent to and connected to the power generation zone (4), and a lower surface fitted to the upper surface of the vehicle roof.

4. The photovoltaic vehicle roof according to claim 3, wherein the generatrix of the power generation zone (4) is perpendicular to a front-rear direction of the vehicle roof,
optionally, the generatrix of the power generation zone (4) is parallel to a front-rear direction of the vehicle roof.

5. The photovoltaic vehicle roof according to claim 2 or 3, wherein the power generation zone (4) is provided with a though hole or recess into which a junction box of the flexible photovoltaic thin-film module (1) is disposed with a sealed connection between an edge of the junction box and the through hole or recess,
preferably, the recess has a depth the same as a thickness of the junction box.

6. The photovoltaic vehicle roof according to claim 1, wherein the flexible photovoltaic thin-film module (1) is in a sealed connection with the power generation zone (4).

7. The photovoltaic vehicle roof according to claim 1,
wherein the power generation zone (4) has a single-curved surface shape, the transition zone includes two first transition zones (2,3) respectively connected to two arc edges of the power generation zone (4) and two second transition zones (3,2) respectively connected to two linear edges of the power generation zone (4);
wherein the first transition zone (2,3) has a single-curved surface shape, an upper edge at a side thereof tangent to and connected to the power generation zone (4), and a lower surface fitted to an upper surface of the vehicle roof; and
wherein the second transition zone (3,2) has a single-curved surface shape, an upper edge at a side thereof tangent to and connected to the power generation zone (4), and a lower surface fitted to the upper surface of the vehicle roof.

8. The photovoltaic vehicle roof according to claim 1, wherein the power generation zone (4) is a recess bottom surface (4) of a recess disposed in the middle of the structural layer.

9. The photovoltaic vehicle roof according to claim 8, wherein an upper surface of the flexible photovoltaic thin-film module (1) is in a smooth transition with an upper surface of the transition zone.

10. The photovoltaic vehicle roof according to claim 8, wherein the recess bottom surface (4) has a flat-plate shape, the transition zone includes two first transition zones (2,3) respectively corresponding to two opposite sides of the recess bottom surface (4) and two second transition zones (3,2) respectively corresponding to other two sides of the recess bottom surface (4), the first and second transition zones both have a single-curved surface shape and a generatrix parallel to a corresponding edge of the recess bottom surface (4).

11. The photovoltaic vehicle roof according to claim 8,
wherein the recess bottom surface (4) has a single-curved surface shape, the transition zone includes two first transition zones (2,3) respectively corresponding to two arc edges of the recess bottom surface (4) and two second transition zones (3,2) respectively corresponding to two linear edges of the recess bottom surface (4);
wherein the first transition zone (2,3) has a hyperboloid shape, and an upper edge at a side thereof parallel to an arc edge of the recess bottom surface (4); and
wherein the second transition zone (3,2) has a single-curved surface shape, and a generatrix parallel to a generatrix of the recess bottom surface (4).

12. The photovoltaic vehicle roof according to claim 11, wherein the generatrix of the recess bottom surface (4) is parallel to a front-rear direction of the vehicle roof,
optionally, the generatrix of the recess bottom surface (4) is perpendicular to a front-rear direction of the vehicle roof.

13. The photovoltaic vehicle roof according to claim 8, wherein the recess bottom surface (4) is provided with a though hole or sink into which a junction box of the flexible photovoltaic thin-film module (1) is disposed.

14. The photovoltaic vehicle roof according to claim 8, wherein a distance from the flexible photovoltaic thin-film module (1) to a side of the recess is no greater than 10mm,
preferably, the flexible photovoltaic thin-film module (1) is in a sealed connection with the recess bottom surface (4) or side at least at an edge, and a sealing material is filled between the flexible photovoltaic thin-film module (1) and the recess side.

15. The photovoltaic vehicle roof according to claim 8,
wherein the recess is a channel with an opening connected to a vehicle body at both ends and two closed sides connected to the transition zone; and
wherein a bottom surface (4) of the channel has a flat-plate or sing-curved surface shape.
